# EUROPEAN PATENT APPLICATION

(11) **EP 4 629 506 A1**
(43) Date of publication of application: **08.10.2025**
(21) Application number: 24168201.2
(22) Date of filing: 03.04.2024
(51) Int. Cl.: H03F 3/185, H03F 3/217, H03F 3/45

(54) **COMMON MODE CONTROL FOR LOW DUTY CYCLE**

(71) Applicant: Goodix Technology (HK) Company Limited, Sheung Shui (HK)
(72) Inventor: Berkhout, Marco, 6537 TL Nijmegen (NL); Koerts, Mattheus Johan, 6537 TL Nijmegen (NL)
(74) Representative: Nederlandsch Octrooibureau

(57) **Abstract**

A differential amplifier circuit comprising a PWM modulator for generating a PWM signal representative of a difference between the first and the second staircase like reference signals and the digital input signal, a DM-IDAC for receiving the PWM signal and providing a first and second differential mode current, a CM-IDAC for receiving the PWM signal and providing a common mode current, first and second loop integrators, and first and second comparators; each loop integrator comprising virtual ground node terminal for receiving the differential mode current, the common mode current, and a feedback signal from an output stage of the differential amplifier circuit via a feedback loop, and integrator output terminal for providing loop integrator output signal proportional to an integral of the signals received at the virtual ground node terminal, the comparators receiving the loop integrator output signal, triangular reference signal, and providing drive signal to output stage.

## Description

### FIELD OF THE INVENTION

The present invention relates to a method and/or circuit for common mode control for low duty cycle using pulse wide modulation.

### BACKGROUND OF THE INVENTION

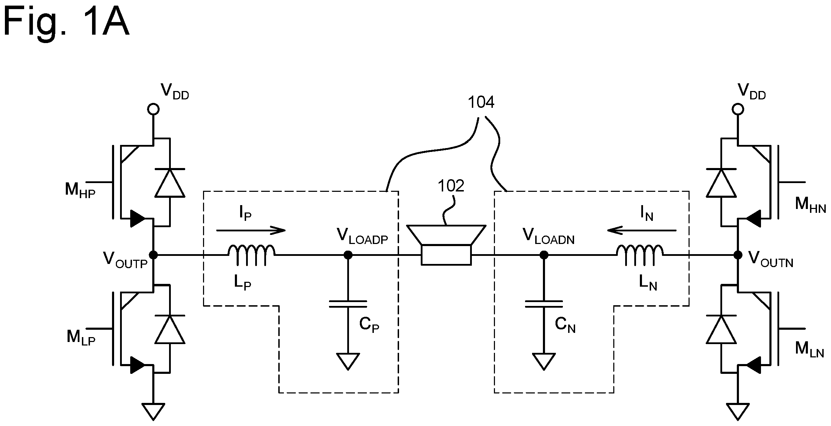

Class-D amplifiers are nowadays preferred in many applications because of their superior power efficiency. Most class-D amplifiers use the so-called Bridge-Tied-Load (BTL) configuration where the loudspeaker load is connected between two outputs that are driven with opposite phase. A typical class-D output stage configuration is shown in figure 1A. The nodes *V_{OUTP}* and *V_{OUTN}* are alternately connected to supply or ground (GND) by means of power Field Effect Transistors (FET) *M*_{*HP*/*LP*} and *M*_{*HN*/*LN*} respectively. Usually, a Pulse Width Modulation (PWM) scheme is used where the nodes *V*_{*OUTP*/*N*} switch at a frequency much higher than the audio band, e.g. 384 kilohertz (kHz), and a duty cycle of *V*_{*OUTP*/*N*} is modulated by the low-frequency (audio) signal.

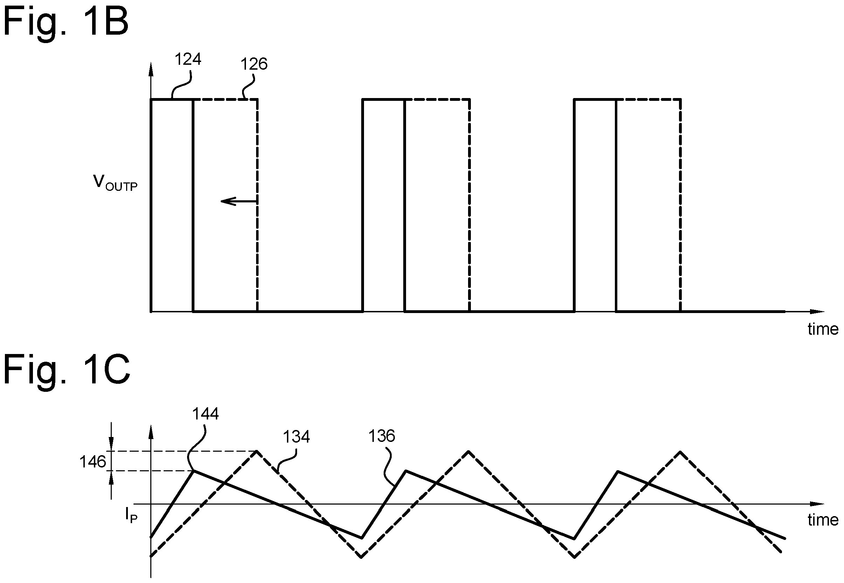

The loudspeaker 102 is shielded from the high-frequency switching by means of an LC lowpass filter 104 that is connected between the switching nodes *V_{OUTP}* and *V_{OUTN}* and the loudspeaker 102. This results in triangular ripple currents Iₚ and I_{N} respectively flowing through the inductors Lₚ and L_{N} in the LC filters 104. The peak-to-peak value of the ripple currents depend on the duty-cycle of the switching nodes as shown in figures 1B and 1C.

The vertical axis of Figure 1B corresponds to *V_{OUTP}* and the horizontal axis to time. The vertical axis of Figure 1C corresponds to *I_{P}* and the horizontal axis to time. Line 126 in Figure 1B shows *V_{OUTP}* as a function of time when switching with 50% duty-cycle which results in a symmetrical triangular ripple current *Iₚ* through inductor *L_{P}* shown a line 134 in Figure 1C. Line 124 in Figure 1B shows *V_{OUTP}* when switching with 20% duty-cycle. In this situation, the ripple current *I_{P}* shown as line 134 in Figure 1C becomes asymmetrical and has a 36% reduced peak-to-peak value as lines 144 and 146 illustrate in Figure 1C. The same holds for *V_{OUTN}* and the ripple current through inductor *L_{N}.*

A reduction of 36% in peak-to-peak value of the ripple current *I_{P}* corresponds to a 59% reduction in the corresponding root mean square (RMS) value of the ripple current *I_{P}* and associated conduction loss in the class-D output stage. Therefore, it is beneficial to have both bridge halves switching at a duty-cycle lower than 50%. This technique is generally referred to as low duty-cycle (LDC) PWM operation. Actually, the effect on the ripple is the same for 20% duty-cycle and 80% duty-cycle. The reason to prefer the lower duty-cycle is that it results in a lower common-mode (CM) voltage which aligns better with the common mode reference voltage V_{CM} of the feedback loop.

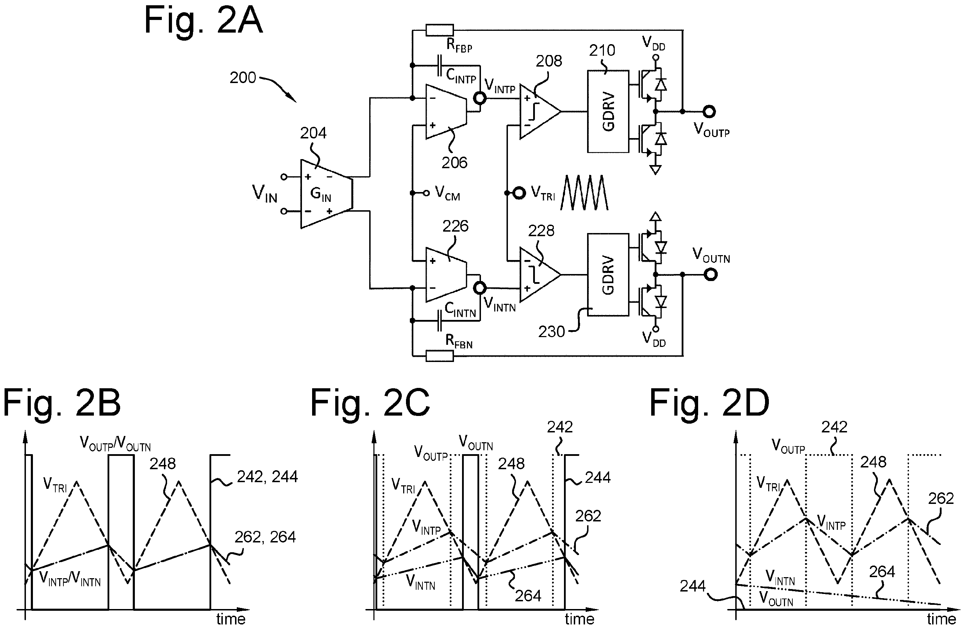

In class-D amplifiers, feedback is used to improve distortion and supply rejection. Figure 2A shows an amplifier 200 with a typical 1^{st} order class-D feedback loop used in LDC PWM operation. The input signal *V_{IN}* is converted to a differential current by a transconductance *G_{IN}* 204 and injected into the virtual ground nodes (the inverting inputs) of two integrators 206 and 226. The outputs of the integrators *V*_{*INTP*/*N*} are compared to a triangular reference signal *V_{TRI}* by comparators 208 and 228 resulting in PWM signals that drive the output nodes *V*_{*OUTP*/*N*} through the gate drivers (GDRV) 210 and 230.

A common mode reference voltage *V_{CM}* connected to the non-inverting inputs of the integrators 206 and 226 determines the common-mode voltage of the outputs *V_{OUTP}* and *V_{OUTN}.* LDC operation occurs when *V_{CM}* << *V_{DD}*/*2* wherein *V_{DD}* is the supply voltage. If, for example, the supply voltage *V_{DD}* is equal to 12.5V and the common mode reference voltage *V_{CM}* is equal to 2.5V, the duty cycle of the outputs *V*_{*OUTP*/*N*} will be V_{CM}/V_{DD} = 2.5/12.5 = 20%. Figure 2B shows the corresponding steady-state integrator outputs *V_{INTP}* and *V_{INTN}* as lines 262 and 264 the triangular reference signal *V_{TRI}* as line 248 and the output node signals *V_{OUTP}* and *V_{OUTN}* as lines 242 and 244 when zero input signal is applied. In this case *V*_{*INTP*/*N*} and *V*_{*OUTP*/*N*} are the same for both bridge halves. When a small positive input signal is applied, the duty-cycle of *V_{OUTP}* increases and the duty-cycle of *V_{OUTN}* decreases as shown in Figure 2C. When increasing the input signal further, the duty-cycle of *V_{OUTN}* will reach 0%. At this input signal level, the duty-cycle of *V_{OUTP}* is still much lower than 100%. In the example shown in figure 2D the duty-cycle of *V_{OUTP}* is about 45% at the moment that *V_{OUTN}* stops switching. In that case *V_{OUTN}* stops switching and the integrator output *V_{INTN}* drops below the range of reference triangle *V_{TRI}* as shown in Figure 2D.This phenomenon is known as "clipping".

This causes severe distortion in the differential output signal *V_{OUTP}*-*V_{OUTN}*. On the other hand, when one bridge-half stops switching this reduces transition and switching losses which is beneficial for efficiency.

US Patent 8,013,677 B2 describes a class-D amplifier with LDC PWM operation where one bridge-half stops switching at higher signal levels. Distortion is mitigated by adding a common mode signal inside the feedback loop just before the comparators. This common mode signal is generated with analog signal processing by rectifying the slightly attenuated differential mode signal. This puts emphasis on the signal processing off the bridge-half that continues switching. The remaining distortion is suppressed by fully differential feedback loop.

US Patent 9,559,648 B2 describes a class-D amplifier where the common-mode level is adjusted dynamically depending on the level of the input signal. For small input signals the common mode level is reduced resulting in LDC PWM operation and reduced idle power loss. For large input signals the common-mode level is increased to avoid clipping and reduce distortion.

US 10,566,939 B2 describes a class-D feedback loop where current Digital-to-Analog Converters (DACs) are used to inject common-mode current pulses into the virtual ground nodes of the loop integrators to keep the loop in regulation when one output rails to ground (GND) or when the output is clipping to the supply voltage VDD. The current pulses start when the integrator output fails to cross the reference triangle and stop when the integrator output returns within the range of the reference triangle. Ideally, for stable operation with no subharmonic oscillations, these pulses need to be short with respect to the PWM period. As a result, the magnitude of the current pulses needs to be rather high, i.e. 2-5 times the magnitude of the input signal current. This allows to adjust the common-mode level dynamically depending on the level of the input signal. For small input signals the common mode level is reduced resulting in LDC PWM operation and reduced idle power loss. For large input signals the common-mode level is increased to avoid clipping and reduce distortion.

US 10,367,460 B2 describes a class-D amplifier with a digital input that uses a 3-level current DAC to drive an analog PWM feedback loop.

There is a need for an amplifier circuit in DM that allows one bridge-half to stop switching while maintaining low distortion.

### SUMMARY OF THE INVENTION

The invention relates to a differential amplifier circuit comprising a pulse width modulation, PWM, modulator configured to receive a digital input signal and process the digital input signal and first and second staircase like reference signals to generate a PWM signal, wherein the PWM signal is representative of a difference between the first and the second staircase like reference signals and the digital input signal; a differential mode current digital to analog converter, DM-IDAC, configured to receive the PWM signal from the PWM modulator and provided a first and second differential mode current; a common mode IDAC, CM-IDAC, configured to receive the PWM signal from the PWM modulator and provide a common mode current; a first and a second loop integrator; and a first and a second comparator; wherein each of the first and second loop integrators (320) comprise a virtual ground node terminal configured to receive the differential mode current from the DM-IDAC, the common mode current from the CM-IDAC, and a feedback signal from an output stage of the differential amplifier circuit via a feedback loop; and an integrator output terminal configured to provide a loop integrator output signal, which is proportional to an integral of the signals received at the virtual ground node terminal; wherein each of the first and second comparators comprise: a comparator non-inverting input terminal configured to receive the loop integrator output signal; a comparator inverting input terminal configured to receive a triangular reference signal; and a comparator output terminal configured to provide a drive signal suitable for driving an output stage of the amplifier circuit. This allows controlling the common-mode part without affecting the differential-mode part which is advantageous because the differential-mode part is the part that contains the signal to be reproduced at the loudspeaker so it needs to remain as is. The common-mode part affects the efficiency of the amplifier. By controlling the common-mode part without affecting the differential-mode part according to the invention, the ripple currents I_{P} and I_{N} and switching activity of *V*_{*OUTP*/*N*} are reduced. The claimed solution is also more hardware efficient and more robust.

The differential amplifier circuit may further comprise another two loop integrators and an sum module after each of the loop integrators. The cascade of the three loop integrators forms a third order loop filter in each half bridge. The sum module in each half bridge generates a weighted sum of the outputs of each the three loop integrators. This higher order loop filter configuration increases the loop gain which results in lower distortion at the output of the differential amplifier.

The DM-IDAC may comprise four current sources and four switches wherein each of the current sources may be arranged to generate a first reference current, and wherein the DM-IDAC may be arranged to receive four control signals to respectively control the four switches and to generate, based on the received four control signals, the first and second differential mode currents to drive the virtual ground nodes terminals. This provides a fast and power efficient way of generating the first and second differential currents.

The four control signals may be generated by the DPWM modulator and each of the first and second differential mode currents may be equal to I_{REF}, -I_{REF} or zero.

The first differential mode current may be equal to I_{REF} if the first staircase like reference signal (*REF_{P}*) is below the digital input signal; to -I_{REF} if the second staircase like reference signal (*REF_{N}*) is above the digital input signal; and to zero otherwise.

The second differential mode current may be equal to I_{REF} if the first staircase like reference signal (*REF_{P}*) is below the inverse of the digital input signal; to -I_{REF} if the second staircase like reference signal (*REF_{N}*) is above the inverse of the digital input signal; and to zero otherwise.

The CM-IDAC may comprise other four current sources and other four switches wherein each of the other four current sources may be arranged to generate a second reference current, and wherein the CM-IDAC may be arranged to receive other two control signals to respectively control the other four switches and to generate, based on the received other two control signals, a common mode current to drive the virtual ground nodes terminals.

The other two control signals may be generated by the DPWM modulator and the common mode current may be equal to I_{REF}/2, I_{REF} or zero.

The common mode current may be equal to I_{REF} if a shifted version of the first staircase like reference signal is below the digital input signal and a shifted version of the second staircase like reference signal is above the inverse of the digital input signal; and to I_{REF}/2 if the shifted version of the first staircase like reference signal is below the digital input signal **or** the shifted version of the second staircase like reference signal is above the inverse of the digital input signal; and to zero otherwise.

The shifted version of the first and second staircase like reference signals may be respectively generated by adding a value N_{SKIP} to the first staircase like reference signal and by subtracting the value N_{SKIP} to the second staircase like reference signal.

The differential amplifier circuit may be further configured to generate a feedback common mode current, wherein the feedback common mode current may be equal to I_{REF}/2 between a first and a second time wherein the first time may be a time at which the triangular reference signal reaches its minimum value and the loop integrator output signal of the first loop integrator or the loop integrator output signal of the second loop integrator may be below the minimum value, and the second time may be another time at which the loop integrator output signal of the first loop integrator or the loop integrator output signal of the second loop integrator reaches the minimum value. By controlling the common-mode level at the output of the differential amplifier using both feedforward control through the generation of the common mode current, and feedback control through the generation of the feedback common mode current, a more stable system is provided. The feedforward component (the common mode current) provides the largest part of the regulation of the differential amplifier while the feedback component (the feedback common mode current) only needs to correct for the impact of voltage and/or temperature dependencies and mismatches in the circuit of the differential amplifier and is therefore relatively small. Because the feedback component is smaller, the system may be more stable. As said, the combination of feedforward and feedback for the common-mode control has the advantage that the feedback part only needs to correct for the error that remains after the feedforward part already did most of the necessary work. This means that the current pulses produced by the common-mode feedback are relatively short and have low magnitude (the required charge to correct the loop is small). When driven with a sufficiently large input signal (When the differential signal amplitude exceeds 2×V_{CM}) one bridge-half of the class-D amplifier stops switching which reduces transition loss and improves efficiency.

The CM-IDAC may be arranged to generate the feedback common mode current. In this way, CM-IDAC generates both the common mode current and the feedback common mode current. This is possible because the feedback common mode current and the common mode current should be generated, at different non overlapping times, allowing to reuse the same circuit for the generation of both. This provides a faster and more power efficient differential amplifier as DACS are analog components with strict speed and accuracy requirements that cause it to consume more area and power.

The differential amplifier circuit may comprise another IDAC configured to generate a current if, when the triangular reference signal reaches its maximum value, the loop integrator output signal of the first loop integrator or the loop integrator output signal of the second loop integrator is above the maximum value. This avoids that the output of the differential amplifier diverges to V_{CC}.

The DM-IDAC may be configured to stop generating the first and second differential mode currents if, when the triangular reference signal reaches its maximum value, the loop integrator output signal of the first loop integrator or the loop integrator output signal of the second loop integrator is above the maximum value. This allows to regulate the clipping behaviour by interrupting the input signal when the integrator outputs exceed the range of reference triangle *V_{TRI}* instead of adding current pulses with a feedback DAC. This is done by controlling the signals driving the DM-IDAC in the digital domain which is more hardware efficient than the prior art.

The differential amplifier circuit may comprise at least one of a first, second, third and fourth extra comparators respectively configured to compare a maximum value of the triangular reference signal and the loop integrator output signal of the first loop integrator, a minimum value of the triangular reference signal and the loop integrator output signal of the first loop integrator, the maximum value and the loop integrator output signal of the second loop integrator, and the minimum value and the loop integrator output signal of the second loop integrator. This is an efficient implementation that allows to avoid the clipping behaviour of the differential amplifier.

The differential amplifier circuit may comprise at least one of a first, second and third switch respectively configured such that the non-inverting input of the first comparator is coupled to a first set of switches and the non-inverting input of the second comparator is coupled to a second set of switches wherein each of the first and second sets of switches comprises a first, second and third switch respectively coupled to the maximum value, the minimum value and the triangular reference signal.

### SHORT DESCRIPTION OF DRAWINGS

In the following, aspects of the invention will be elucidated by means of examples, with reference to the drawings in which:
Fig. 1A shows a schematic of a circuit comprising a load driven by the output stages of a differential amplifier according to the prior art.
Figs. 1B and 1C show diagram representations of several signals of the differential amplifier of Fig. 1A.
Fig. 2A shows a schematic of a circuit of a differential amplifier.
Figs. 2B-2D show diagram representations of several signals of the differential amplifier of Fig. 2A.
Figs. 3A and 3B shows a schematic of a circuit of a differential amplifier according to embodiments of the invention.
Fig. 4A shows a schematic of a circuit of the DM-IDAC of the differential amplifier of Fig. 3A according to an embodiment of the invention.
Figs. 4B, 4C-I and 4C-II show diagram representations of several signals of the differential amplifier of Fig. 3A.
Fig. 5A shows a schematic of a circuit of the CM-IDAC of the differential amplifier of Fig. 3A according to an embodiment of the invention.
Figs. 5B-5E 6, 7A-7B and 8A-8C, 9A-9B show diagram representations of several signals of the differential amplifier of Fig. 3A according to embodiments of the invention.
Figs. 10 and 11 shows schematics of circuits of differential amplifiers according to embodiments of the invention.

### DESCRIPTION OF EMBODIMENTS

Examples will now be described, by way of illustration only, with reference to the accompanying schematic drawings in which corresponding reference symbols indicate corresponding parts. In the drawings, like numerals designate like elements. Multiple instances of an element may each include separate letters appended to the reference number. For example, two instances of a particular element "112" may be labeled as "112a" and "112b". The reference number may be used without an appended letter (e.g., "112") to generally refer to an unspecified instance or to all instances of that element, while the reference number will include an appended letter (e.g., "112a") to refer to a specific instance of the element.

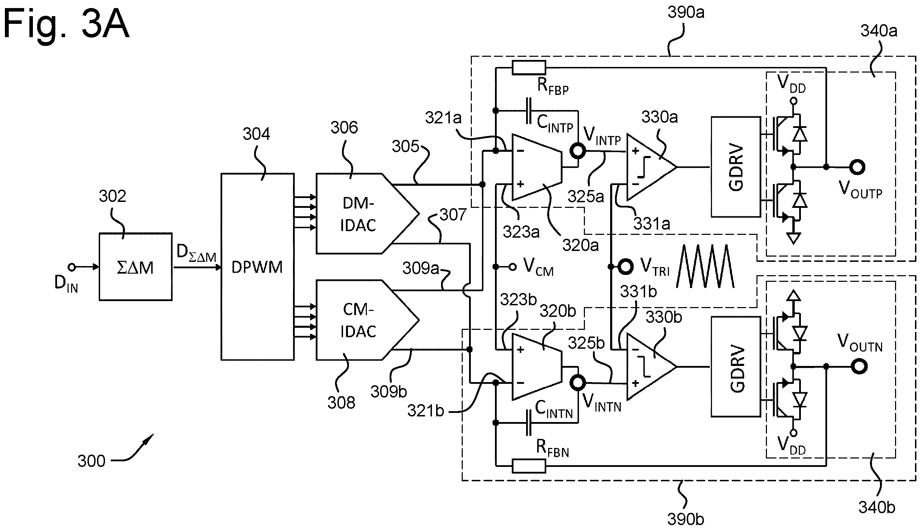

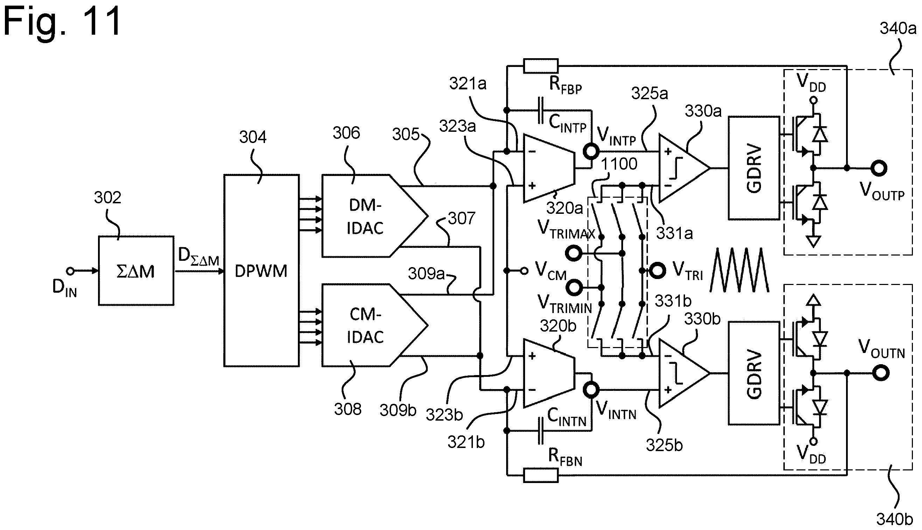

Figure 3A shows an amplifier circuit 300 according to an embodiment of the invention. The amplifier circuit 300 of Figure 3A comprises a sigma delta modulator 302, a delta-PWM (DPWM) modulator 304, a differential-mode current-DAC (DM-IDAC) 306 and a common-mode current-DAC (CM-IDAC) 308. The sigma delta modulator 302 is configured to receive a digital input signal D_{IN}. The digital input signal D_{IN} may be an oversampled high resolution digital input signal comprising, for instance, 24 bits. The sigma delta modulator 302 is further configured to generate an output signal *D_{ΣΔM}* which is a quantized version of the digital input signal D_{IN} with less bits, for instance, with 8 bits, and wherein the resulting quantization noise has been shaped out of the audio bandwidth. The DPWM modulator 304 is configured to receive the output signal *D_{ΣΔM}* from the sigma delta modulator 302 and to generate a three level analog DPWM signal (that is, an analog DPWM signal that can have three different values or levels) which is then sent to the DM-IDAC 306 and to the CM-IDAC 308. The DM-IDAC 306 generates differential mode current I_{DMP} at line 305 and differential mode current I_{DMN} in line 307 as shown in Fig. 11. The CM-IDAC 308 generates common mode current I_{CM} at both lines 309a and 309b as also shown in Fig. 11.

The differential amplifier circuit 300 of Figure 3A also comprises loop integrators 320a and 320b. The loop integrator 320a comprises an integrator non-inverting input terminal 323a, an integrator inverting input terminal (or virtual ground node terminal) 321a and an integrator output terminal 325a. The loop integrator 320b comprises an integrator non-inverting input terminal 323b, an integrator inverting input terminal (or virtual ground node terminal) 321b and an integrator output terminal 325b. The integrator non-inverting input terminals 323a of the loop integrators 320a are configured to receive a common mode reference voltage V_{CM}. The integrator inverting input terminal 321a of the loop integrator 320a is a virtual ground node terminal configured to receive a feedback signal from an output stage 340a, which generates an output voltage V_{OUTP}, of the differential amplifier circuit via a feedback loop 390, a differential mode current I_{DMP} from the DM-IDAC 306, and the common mode current I_{CM} from the CM-IDAC 308. The CM-IDAC 308 can only sink current which means current I_{CM} flows into CM-IDAC 308. The integrator inverting input terminal 321b of the loop integrator 320b is also a virtual ground node terminal configured to receive a feedback signal from another output stage 340b, which generates an output voltage V_{OUTN}, of the differential amplifier circuit 300 via a feedback loop 390, the differential mode current I_{DMN} from the DM-IDAC 306, and the common mode current I_{CM} from the CM-IDAC 308.

The integrator output terminals 325 of the loop integrators 320 are configured to respectively provide loop integrator output signals V_{INTP} and V_{INTN} which are proportional to an integral of the signals received at the respective integrator inverting terminals 321of the loop integrators 320.

The differential amplifier circuit 300 of Figure 3A also comprises comparators 330a and 330b. The comparator 330a comprises a comparator non-inverting input terminal configured to receive V_{INTP}, a comparator inverting input terminal 331a and a comparator output terminal. The comparator 330b comprises a comparator non-inverting input terminal configured to receive V_{INTN}, a comparator inverting input terminal 331b and a comparator output terminal. The comparator inverting input terminals 331 of each of the comparators 330 are configured to receive a triangular reference signal V_{TRI} that corresponds to the integral of a square wave carrier signal. The comparator non-inverting input terminal of the comparator 330a is connected to the integrator output terminal 325a of the loop integrator 320a and the comparator non-inverting input terminal of the comparator 330b is connected to the integrator output terminal 325b of the loop integrator 320b. The comparator output terminal of each of the comparators 330a and 330b is configured to provide a drive signal suitable for respectively driving the output stages 340a and 340b of the differential amplifier circuit 300. The Gate Drivers GDRV respectively translates the output signals of the comparators 330a and 330b to appropriate drive signals for the gates of the power FETs of the output stages 340a and 340b. This includes level shifting for the high side power FET and break-before-make timing to prevent that in each the output stages 340a and 340b both power FETs conduct simultaneously.

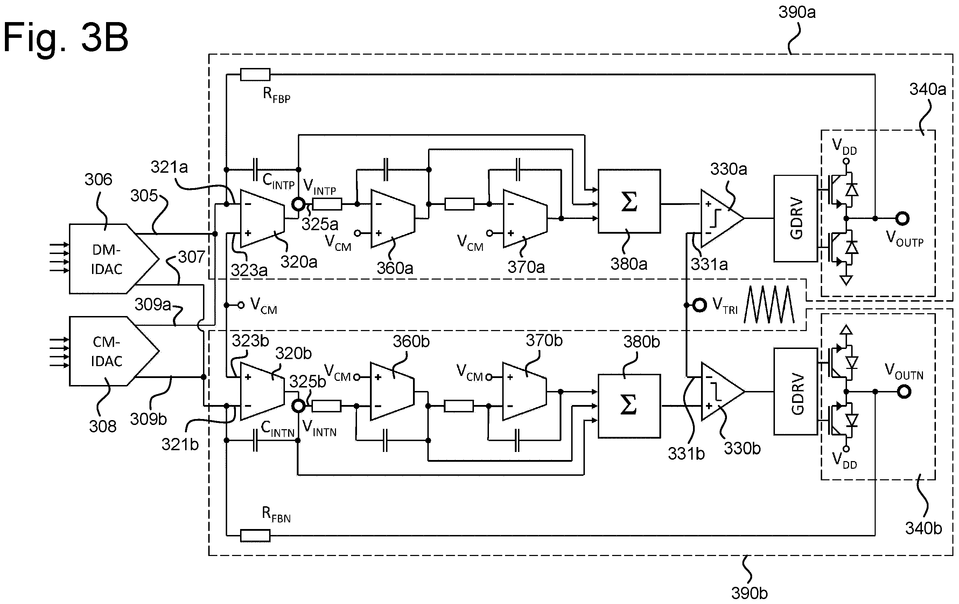

Fig. 3B shows a modification of the differential amplifier circuit of Fig. 3A. The differential amplifier circuit of Fig. 3B is identical to the differential amplifier circuit of Fig. 3A with the addition of another two loop integrators 360 and 370 and a sum module 380 after each of the loop integrators 320a and 320b. The cascade of the three loop integrators 320, 360 and 370 forms a third order loop filter in each half bridge. The sum module 380 in each half bridge generates a weighted sum of the outputs of each the three loop integrators. The weighing of integrator outputs is to achieve a stable loop transfer. As the gain of the configuration of the three loop integrators is equal to the multiplication of the gains of the three loop integrators, this higher order loop filter configuration increases the loop gain which results in lower distortion at the output of the differential amplifier. The gain of the integrators multiply and more integrators contribute to more gain. As shown in Fig. 3B, the output of the loop integrator 320 is connected to the inverting input of the loop integrator 320, to the sum module 380 and to the inverting input of the loop integrator 360, the output of the loop integrator 360 is connected to the inverting input of the loop integrator 360, to the sum module 380 and to the inverting input of the loop integrator 370, and the output of the loop integrator 370 is connected to the inverting input of the loop integrator 370 and to the sum module 380. The non-inverting input of each of the three loop integrators 320, 360 and 370 is connected to V_{CM}. The rest of the description will refer to Fig. 3A but identically applies to Fig. 3B.

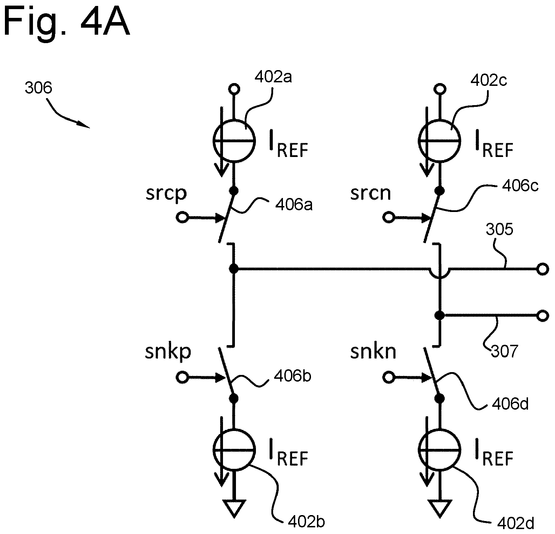

Fig. 4A shows a schematic of a circuit implementation of the DM-IDAC 306 according to an embodiment of the invention. The DM-IDAC 306 comprises four current sources 402a, 402b, 402c and 402d and four switches 406a, 406b, 406c and 406d. Each of the current sources 402 is arranged to generate a reference current I_{REF}. The DM-IDAC 306 is arranged to receive four control signals *srcp, snkp srcn,* and *snkn* and generate, based on the received control signals, two current outputs *I_{DMP}* and *I_{DMN}* respectively at lines 305 and 307 that drive the virtual ground nodes of the feedback loop 390 as shown in Fig. 11. Each current *I_{DMP(N)}* can be either +*I_{REF}*, zero or -*I_{REF}*, depending on the control signals *srcp, snkp srcn,* and *snkn* that respectively control the switches 406a, 406b, 406c and 406d. The control signals *srcp, snkp srcn,* and *snkn* are generated by the DPWM modulator 304 as explained below.

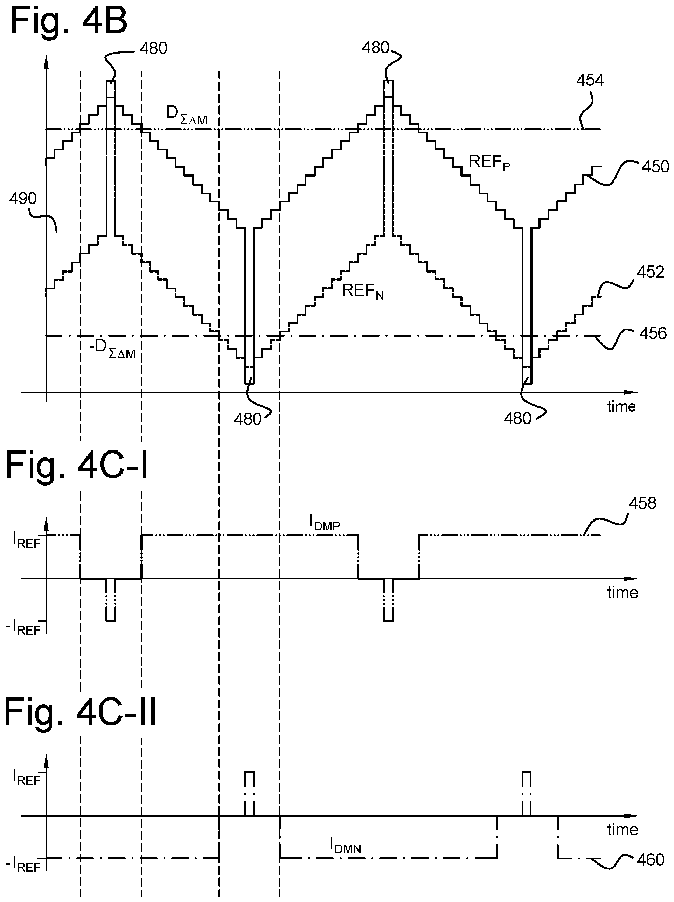

The DPWM modulator 304 of Figure 3A is configured to receive the output signal *D_{ΣΔM}* from the sigma delta modulator 302 and compare the output signal *D_{ΣΔM}* to two staircase-like reference signals *REFp* and *REF_{N}*, wherein the two staircase-like reference signals *REFp* and *REF_{N}* are staircase like signals that are generated inside the DPWM modulator 304 using digital counters. Fig. 4B shows the two staircase-like reference signals *REF_{P}* and *REF_{N}* as a function of time. *REF_{P}* and *REF_{N}* are digital signals and each step of the staircase corresponds to one Least Significant Bit (LSB) and the high and low limits are plus/minus FS (Full Scale). The peaks in the reference signals are there to enforce a constant transition rate of the DPWM signal. US 10,367,460 B2 provides examples of how to generate *REF_{P}* and *REF_{N}*, thought any other suitable method could be used. In Fig. 4B, line 450 represents *PEF_{P}*, line 452 represents line 454 represents *D_{ΣΔM}* , line 456 represents the negative value of *D_{ΣΔM}* and the zero is the horizontal dashed line 490 in the middle.. Fig. 4C-I shows in line 458 the generated current I_{DMP} as a function of time and Fig. 4C-II shows in line 460 the generated current I_{DMN} as a function of time. As it can be seen from Figs. 4B, 4C-I and 4C-II, if the output signal *D_{ΣΔM}* is higher than the staircase-like reference signal *PEF_{P}*, then the current output *I_{DMP}* is positive and equal to I_{REF}. Therefore the DM-IDAC 306 sources a positive current I_{REF} into the virtual ground node of the feedback loop 390. A positive *I_{DMP}* current causes the (average) output voltage *V_{OUTP}* at the output terminal of the amplifier circuit to go down towards ground.

The current *I_{DMP}* from the DM-IDAC 306 and the current I_{CM} from the CM-IDAC 308 are sent towards the virtual ground node of the feedback loop 390 which is connected to the negative terminal of the loop integrator 320a. In a similar way, the current *I_{DMN}* from the DM-IDAC 306 and the current I_{CM} from the CM-IDAC 308 are sent towards the virtual ground node of the feedback loop 390 which is connected to the negative terminal of the loop integrator 320b. To maintain the virtual grounds, the currents provided at the virtual ground nodes need to be compensated by the feedback current flowing through the resistors R_{FBP} and R_{FBN}. So if a positive current flows towards the virtual ground then a negative current of equal magnitude needs to flow from the virtual ground towards the output terminal of the amplifier circuit. In this case, the output voltages V_{OUTP} and V_{OUTP} of the amplifier circuit need to be lower than the voltage on the corresponding virtual ground node. Hence a positive input current in the virtual ground node results in a negative output voltage at the output terminal of the amplifier circuit, and vice versa.

Going back to Figs. 4B, 4C-I and 4C-II, if *D_{ΣΔM}* is lower than *REF_{N}* then *I_{DMP}* sinks a negative current. In all other cases *I_{DMP}* is zero. Output current *I_{DMN}* is generated in a similar way but using the inverse signal -*D_{ΣΔM}*. The peaks 480 on the reference signals *REF_{P}* and *REF_{N}* guarantee that ±*D_{ΣΔM}* crosses each reference signal *REF_{P}* and *REF_{N}* exactly once each period thereby resulting in a constant transition rate and eliminating inter-symbol interference (ISI). As can be seen in Figs. 4B, 4C-I and 4C-II, while *D_{ΣΔM}* is higher than *REF_{P}*, *I_{DMP}* stays positive, and if *D_{ΣΔM}* is lower than *REF_{N}*, then *I_{DMP}* is negative. For *I_{DMN}*, the opposite occurs.

The averages of *I_{DMP}* and *I_{DMN}* are equal in magnitude but have opposite sign. Consequently, at the output V_{OUTP} of the differential amplifier, the (average) value of *V_{OUTP}* goes down, i.e. it's duty-cycle reduces, and the (average) value of *V_{OUTN}* goes up, i.e. it's duty-cycle increases. The duty-cycle of *V_{OUTP}* cannot go below zero. In this case output *V_{OUTP}* stops switching between positive and negative values and this results in severe distortion since essentially one half of the amplifier circuit is now clipping and does not contribute further to the (differential) output signal.

This situation can be prevented by adding the common mode sink current *I_{CM}* to both *I_{DMP}* and *I_{DMN}*. As shown in Fig. 3A, *I_{CM}* is provided by CM-IDAC 308 to the inverting input of the loop integrators and *I_{DMP}* and *I_{DMN}* are respectively provided by DM-IDAC 306 to the inverting input of the loop integrators. The effect of this *I_{CM}* is that the (average) common-mode value of *V_{OUTP}* and *V_{OUTN}* increases whereas the voltage difference between *V_{OUTP}* and *V_{OUTN}* remains unchanged and thus no distortion is caused.

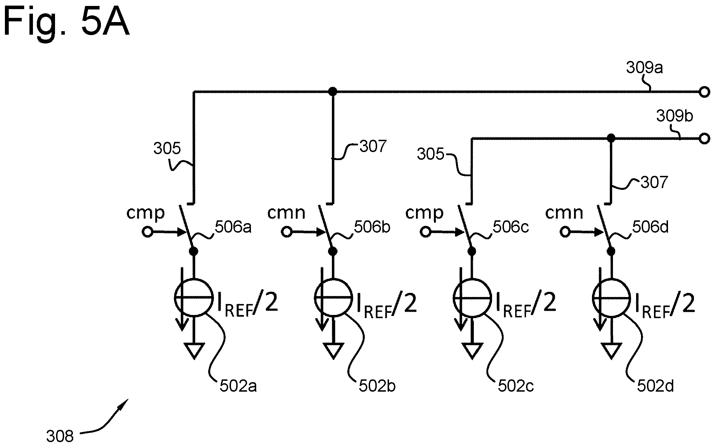

Figure 5A shows a schematic of a circuit implementation of the CM-IDAC 308 according to an embodiment of the invention. The CM-IDAC 308 comprises four current sources 502a, 502b, 502c and 502d and four switches 506a, 506b, 506c and 506d. Each of the current sources 502 is arranged to generate a current *I_{REF}*/2. The CM-IDAC 308 is arranged to receive two control signals *cmp* and *cmn* and generate, based on the received control signals, two identical current outputs *I_{CM}* at lines 309a and 309b (shown in Fig. 11) that respectively drive the virtual ground nodes and are thus respectively summed with the DM-IDAC output currents *I_{DMP}* and *I_{DMN}*. Each *I_{CM}* current is the sum of two currents *I_{CMP}* and *I_{CMN}*. Each current *I_{CM}* can be either 0, *-I_{REF}*/2 or *-I_{REF}*, depending on the control signals *cmp* and *cmn* that control the switches 506 and are generated by the DPWM modulator 304.

In the following, several embodiments for generating *I_{CM}* will be described.

### Feedforward generation of I_{CM}

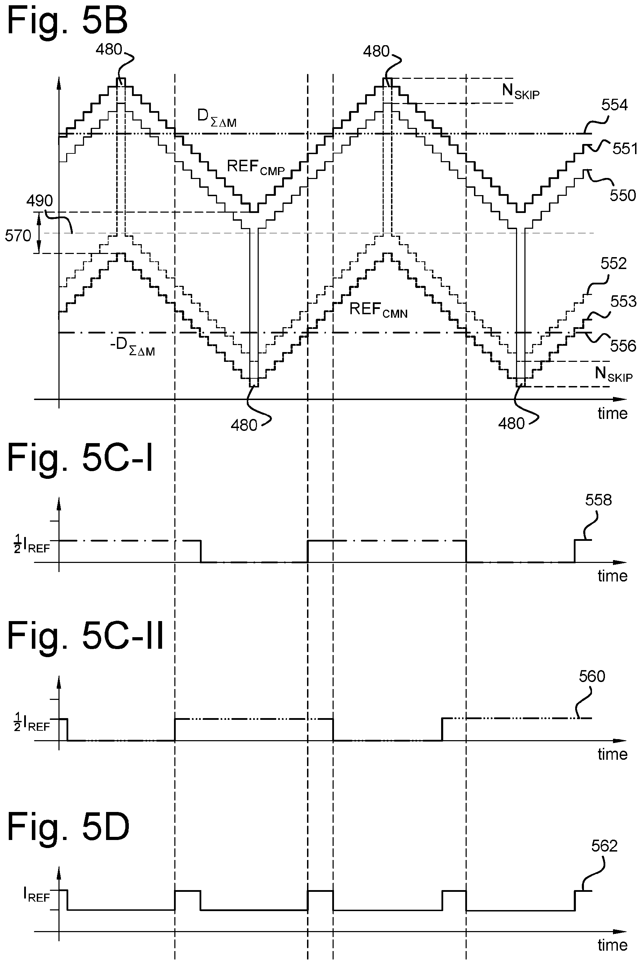

According to this embodiment, the DPWM modulator 304 of Figure 3A is configured to receive the output signal *D_{ΣΔM}* from the sigma delta modulator 302 and compare the output signal *D_{ΣΔM}* to a shifted version of the two staircase-like reference signals *REF_{P}* and *REF_{N}*. Fig. 5B shows the two staircase-like reference signals *REF_{P}* and *REF_{N}* and the shifted versions *REF_{CMP}* and *REF_{CMN}* as a function of time. The peaks 480 of the two staircase-like reference signals *REF_{P}* and *REF_{N}* are removed in the shifted versions *REF_{CMP}* and *REF_{CMN}*. In Fig. 5B-D, line 550 represents *REFp,* line 551 represents *REF_{CMP}* which is the shifted version of *REF_{P}*, line 552 represents line 553 represents *REF_{CMN}* which is the shifted version of *REF_{N}*, line 554 represents *D_{ΣΔM}* and line 556 represents the negative value of *D_{ΣΔM}*. Fig. 5C-I shows in line 558 the current I_{CMN}, and Fig. 5C-II shows in line 560 the current I_{CMP} as a function of time. And Fig. 5D shows in line 562 the generated current I_{CM} as a function of time.

As it can be seen from Figs. 5B-5D, *I_{CM}* can be generated with feedforward by comparing compare *D_{ΣΔM}* to the shifted versions of the references *REFp* and *REF_{N}*. *REF_{CMP}* is shifted up with respect to *REF_{P}* and *REF_{CMN}* is shifted down with respect to *REF_{N}* by the same offset called *N_{SKIP}*.

If *D_{ΣΔM}* is higher than *REF_{CMP}* or lower than *REF_{CMN}* then sinks a current I_{REF}/2, otherwise *I_{CMP}* is zero. If the inverted signal *-D_{ΣΔM}* is higher than *REF_{CMP}* or lower than *REF_{CMN}* then *I_{CMN}* sinks a current I_{REF}/2, otherwise *I_{CMN}* is zero. When both and *I_{CMN}* are sinking current their values are summed together yielding *I_{REF}*.

Because of the offset *N_{SKIP}* that has been applied to the reference signals *REF_{P}* and *REF_{N}* to obtain the shifted versions *REF_{CMP}* and *REF_{CMN}*, there is a range of values for *D_{ΣΔM}* where *I_{CMP}*, and *I_{CMN}* are zero. Line 570 shows an example of an specific value of *D_{ΣΔM}* for which *I_{CMP}* and *I_{CMN}* are zero. This means that for small values of *D_{IN}* (*D_{ΣΔM}*), that is values of *D_{IN}* (*D_{ΣΔM}*) between zero and the minimum value of *REF_{CMP}*, no common-mode currents *I_{CM}* are added and therefore also no noise is added. Ideally, the CM-IDAC 308 is arranged to generate two identical currents *I_{CM}*. However, in a real implementation there will also be noise in the current sources 502 that is uncorrelated so the noise is not strictly common-mode and therefore the noise has a differential-mode component. This differential-mode noise component adds to the differential noise at the output terminals *V_{OUTP}* and *V_{OUTN}.* However, if the common-mode currents *I_{CM}* are zero no additional noise will be produced.

So for small values of the input signal *D_{IN}* (*D_{ΣΔM}*), it is advantageous that *I_{CM}* is zero to improve the differential noise. For large values of the input signal *D_{IN}* (*D_{ΣΔM}*), it is advantageous to generate non zero *I_{CM}* to prevent distortion as the added noise will be masked by the value of the input signal *D_{IN}* thereby becoming inaudible.

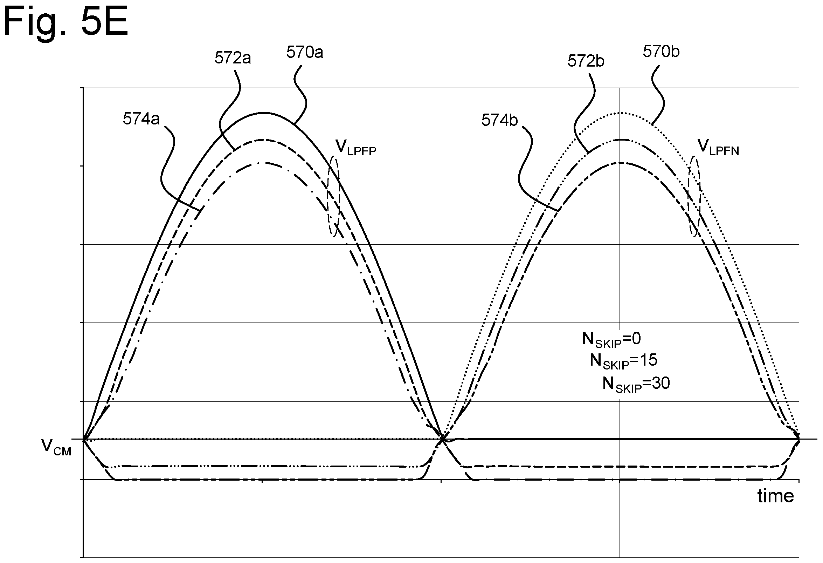

The effect of the feedforward common-mode current *I_{CM}* is that it fixes the lowest level of the average value of either *V_{OUTP}* or *V_{OUTN}* depending on the value of *N_{SKIP}*. Figure 5E shows an example of *V_{LPFP}* and *V_{LPFN}*, which are the respective (low-pass filtered) single-ended outputs *V_{OUTP}* and *V_{OUTN}* as a function of time for different values of *N_{SKIP}*. At zero value of the input signal *D_{IN}* both *V_{LPFN}* and *V_{LPFP}* equal *V_{CM}*. For positive values of the input signal *D_{IN}*, *V_{LPFP}* increases with respect to *V_{CM}* and *V_{LPFN}* decreases with respect to *V_{CM}*.

As shown in Fig. 5E, when *N_{SKIP}* equals zero, neither *V_{LPFP}* nor *V_{LPFN}* respectively represented as lines 570a and 570b will go below the common mode reference voltage *V_{CM}*. In this case the common mode feedforward current *I_{CM}* generated by CM-IDAC 308 exactly matches the rectified version of the currents *I_{DMP}* and *I_{DMN}* generated by the DM-IDAC 306. This is because, if *N_{SKIP}* equals zero, the shifted versions *REF_{CMP}* and *REF_{CMN}* fall on top of the reference signals *REFp* and *PEF_{N}* used to generate the *I_{DMP}* and *I_{DMN}* in the DM-IDAC 306. In this case the common-mode part of *V_{LPFN}* and *V_{LPFP}* becomes a rectified version of the differential-mode part of *V_{LPFN}* and *V_{LPFP}*. In each bridge-halve this means that negative signal excursions are cancelled, and positive excursions are doubled.

As an example, with *N_{SKIP}* having a value equivalent to 15, the minimum level of *V_{LPFP}* and *V_{LPFN}* respectively represented in Fig. 5E by 572a and 572b hovers just above ground. In this case the feedback loop 390 maintains stable regulation but both output stages 340 keep switching. *N_{SKIP}* is a digital value which units are LSB (Least Significant Bit). *N_{SKIP}* having a value equivalent to 15 used in this example is related to the resolution of *D_{ΣΔM}*, and with *D_{ΣΔM}* being a 8-bit signal, its resolution range is -127 to +127. If *D_{ΣΔM}* would be a 9-bit signal, then its range would double and we would have to double N_{SKIP} to get the same behavior. The output signals *V_{OUTP}* and *V_{OUTN}* of both output stages or bridge-halves 340 are PWM signals that can only switch between ground GND and supply *V_{DD}* with a fixed frequency. Only the respective duty-cycle *D_{P}* and *D_{N}* of the output signals *V_{OUTP}* and *V_{OUTN}* is variable. The average value of *V_{OUTP}* equals *D_{P}*V_{DD}* and the average value of *V_{OUTN}* equals *D_{N}*V_{DD.}*.

The output stages or bridge-halves 340 stop switching only if *D_{P}* or *D_{N}* is zero per cent, that is, if *V_{OUTP}* or *V_{OUTN}* is GND; or if *D_{P}* or *D_{N}* is 100 per cent, that is, if *V_{OUTP}* or *V_{OUTN}* is *V_{DD}.* So, if the average value of *V_{OUTP}* or *V_{OUTN}* is between GND and *V_{DD}*, the respective duty-cycle, *D_{P}* or *D_{N}*, is between zero and 100 per cent and thus the corresponding output is switching.

The feedback loop 390 maintains stable operation because the virtual ground nodes are maintained as the current pushed into the virtual ground nodes is matched by the feedback currents.

If, for example, *N_{SKIP}* equals 30, both *V_{LPFP}* and *V_{LPFN}* respectively represented in Fig. 5E by 572a and 572b are clipped to ground. In this case the corresponding bridge-half 340 stops switching and the differential mode signal *V_{LPFP}* - *V_{LPFN}* gets distorted. If one bridge-half stops switching the feedback loop 390 of that bridge-half cannot maintain regulation as more current is pushed into the virtual ground that can be compensated by the feedback loop 390 because the output of the amplifier circuit cannot go lower than GND. If one bridge-half cannot maintain regulation this causes an error in the differential-mode signal which is distortion.

An *N_{SKIP}* value exists that is exactly on the boundary where the feedback loop 390 is still in regulation while one of the bridge halves stops switching. However, this *N_{SKIP}* value is very sensitive to small variations in the amplifier circuit caused by process, supply and temperature changes.

### Feedback generation of I_{CM}

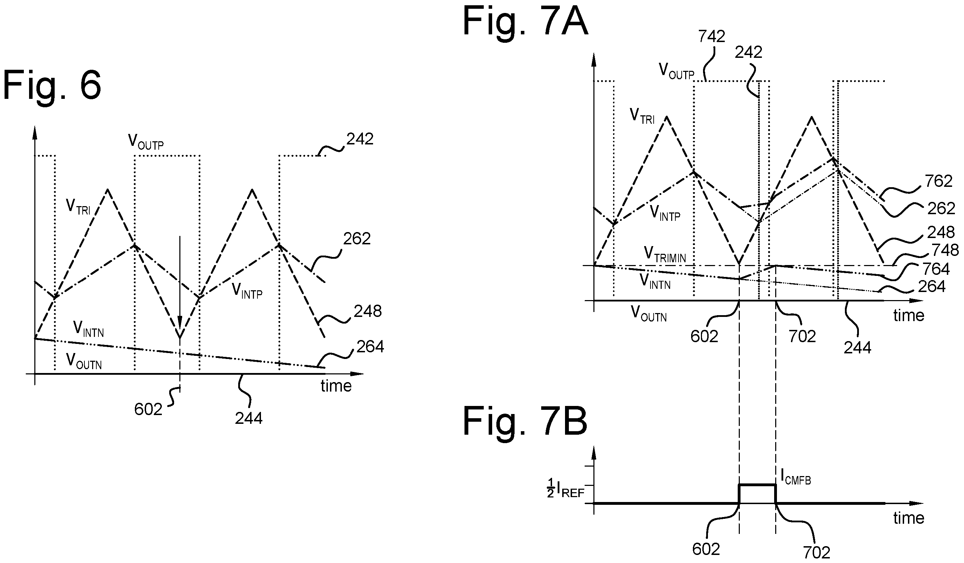

Fig. 6 is identical to Fig. 2B and schematically shows outputs *V_{INTP}* and *V_{INTN}* as lines 262 and 264, the triangular reference signal *V_{TRI}* as line 248, and the output node signals *V_{OUTP}* and *V_{OUTN}* as lines 242 and 244 in the situation when *V_{OUTN}* has stopped switching and the loop integrator output signal *V_{INTN}* at the output terminal 325b of the loop integrator 320b is just over the edge of regulation. As can be seen in Fig. 6, *V_{INTN}* is slowly diverging away from the range of the triangular reference signal *V_{TRI}*. This situation can be detected by identifying a first time 602 at which the value of the loop integrator output signal *V_{INTN}* is below the lowest value *V_{TRIMIN}* of *V_{TRI}*. *V_{TRIMIN}* is represented as line 748 in Fig 7B. A feedback common current *I_{CMFB}* having a value of -1/2I_{REF} and represented by line 700 in Fig. 7B will be generated and send to the virtual ground nodes of the feedback loops 390 at the identified first time 602. The feedback common mode current *I_{CMFB}* will correct the divergence of *V_{INTN}*. Both *V_{INTN}* and *V_{INTP}* will increase such that *V_{INTN}* moves up towards *V_{TRIMIN}* as respectively shown by lines 764 and 762 in Fig. 7B. At a second time 702 when *V_{INTN}* reaches *V_{TRIMIN}*, the generation of the feedback common current *I_{CMFB}* will stop. After that second time 702, *V_{INTN}* will diverge down again and, at the next time that *V_{TRI}* reaches *V_{TRIMIN}*, a new current pulse *I_{CMFB}* will be generated restarting the process.

Because the current sink pulses of *I_{CMFB}* are common mode, not only *V_{INTN}* but also *V_{INTP}* is affected as can be seen in Fig. 7A. The duty-cycle of the output voltage *V_{OUTP}* increases and makes up for the part that is now missing from *V_{OUTN}* as shown by line 742 and the distortion that would otherwise have been caused by *V_{OUTN}* clipping to ground is corrected.

### Combining Feedback and Feedforward generation of I_{CM}

In an embodiment of the invention, the common mode feedback current *I_{CMFB}* could be generated by the CM-IDAC 308 as shown in Fig. 5A that also generates the common mode feedforward common currents *I_{DMP}* or *I_{DMN}*. The common mode feedback current *I_{CMFB}* need to be generated when *V_{TRI}* reaches *V_{TRIMIN}*. As shown in Figs. 5B-5D, in the peaks *REF_{P}* and *REF_{N}* only one of the common mode feedforward common currents *I_{DMP}* or *I_{DMN}* needs to be generated, which means that the other current output of the CM-IDAC 308 is available to generate the common mode feedback current *I_{CMFB}*. Therefore, when the CM-IDAC 308 is not generating the common mode feedforward common current *I_{DMP}* at line 305, the CM-IDAC 308 can generate the common mode feedback current *I_{CMFB}* at that line 305, and when the CM-IDAC 308 is not generating the common mode feedforward common current *I_{DMN}* at line 307, the CM-IDAC 308 can generate the common mode feedback current *I_{CMFB}* at that line 307.

### Supply Clipping Control

Generating both the common mode feedforward currents or *I_{CMN}* and the common mode feedback current *I_{CMFB}* allows that *V_{OUTN}* and *V_{OUTP}* clip to ground while maintaining low distortion. In differential amplifiers wherein *V_{OUTN}* and *V_{OUTP}* working at low duty cycle pulse width modulation, the common mode correction becomes active at relatively low input signal levels. When the input signal level is increased further, the duty-cycle of the output signal *V*_{*OUTN*/*P*} that is still switching increases until it reaches 100%.

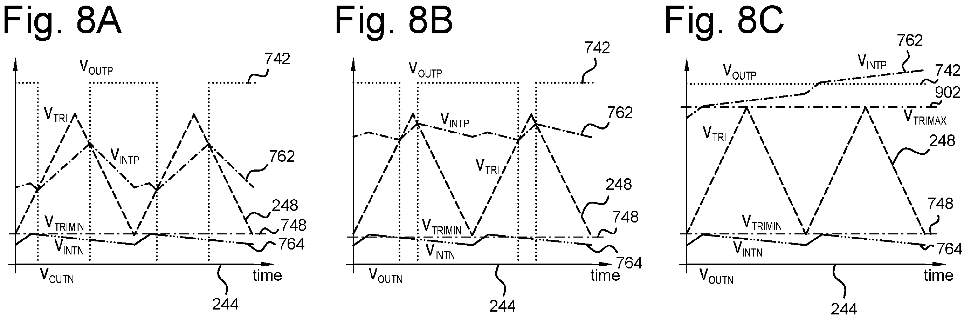

In that case integrator output *V_{INTN}* or *V_{INTP}* of the differential amplifier will clip against the supply rail *V_{DD}* and a similar situation appears as when *V_{INTN}* or *V_{INTP}* are clipping to ground but now when the reference *V_{TRI}* reaches its highest value *V_{TRIMAX}*. Fig. 8A shows *V_{INTN}*, *V_{INTP}*, *V_{OUTN}*, *V_{OUTP}*, *V_{TRI}* and *V_{TRIMIN}* when a large (negative) input signal is applied to the differential amplifier. In this case, the output *V_{OUTN}* is already clipping to ground and the common mode correction as explained above prevents *V_{INTN}* from diverging. When the input signal increases further, the duty-cycle of *V_{OUTP}* increases as can be seen in Fig. 8B. Compared *V_{INTP}* in Fig8A and Fig8B, when the input signal increases further, *V_{INTP}* also increases towards the maximum value *V_{TRIMAX}* of *V_{TRI}*. When the input signal is increased even more the duty-cycle of *V_{OUTP}* becomes 100%, *V_{OUTP}* stops switching and *V_{INTP}* grows above the range of *V_{TRI}* as shown in Fig. 8C.

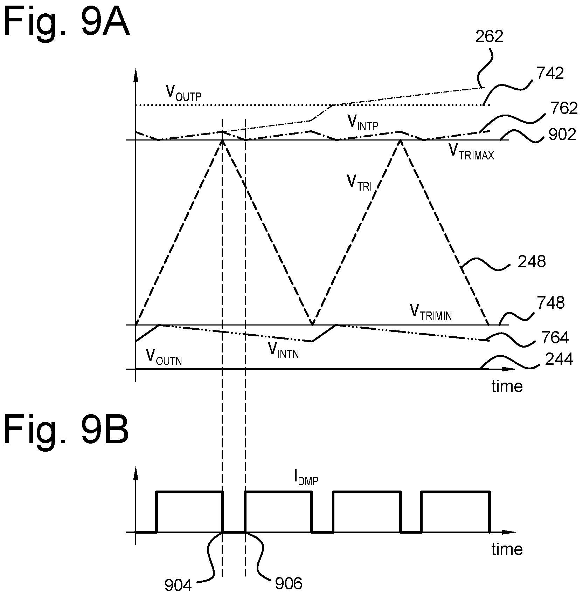

In an alternative embodiment, the DM-IDAC 306 can stop generating *I_{DMP}* or *I_{DMN}* at certain times to prevent *V_{INTP}* from diverging as in Fig. 8C. In this embodiment and as shown in Figs. 9A and 9B, if at a third time 904 when *V_{TRI}* reaches the maximum value *V_{TRIMAX}*, the value of *V_{INTP}* is higher than *V_{TRIMAX}*, then DM-IDAC 306 will stop generating the current *I_{DMP}* until a fourth time 906 at which the value of *V_{INTP}* is below *V_{TRIMAX}* again. The same mechanism applies to the generation of *I_{DMN}* for large positive input signals.

This clipping control arrangement does not prevent distortion: the output cannot be driven beyond the supply rails, that is, the output is clipping to the supply value V_{DD}, and thus distortion is inevitable. However, preventing divergence of the loop integrators results in a smooth and immediate recovery from clipping as soon as the input signal is reduced again. This prevents audible artifacts related to so-called 'sticking' and settling responses.

The Implementation of the complete common-mode feedforward/feedback and clipping control requires the addition of four new comparators to the differential amplifier 300 shown in Figure 3A to compare the outputs *V*_{*INTP*/*N*} to the reference triangle boundaries *V_{TRIMIN}* and *V_{TRIMAX}* and a couple of simple finite-state machines that combine the comparator outputs with the three level analog DPWM signal from the DPWM modulator 304 to drive the DM-IDAC 306 and the CM-IDAC 308.

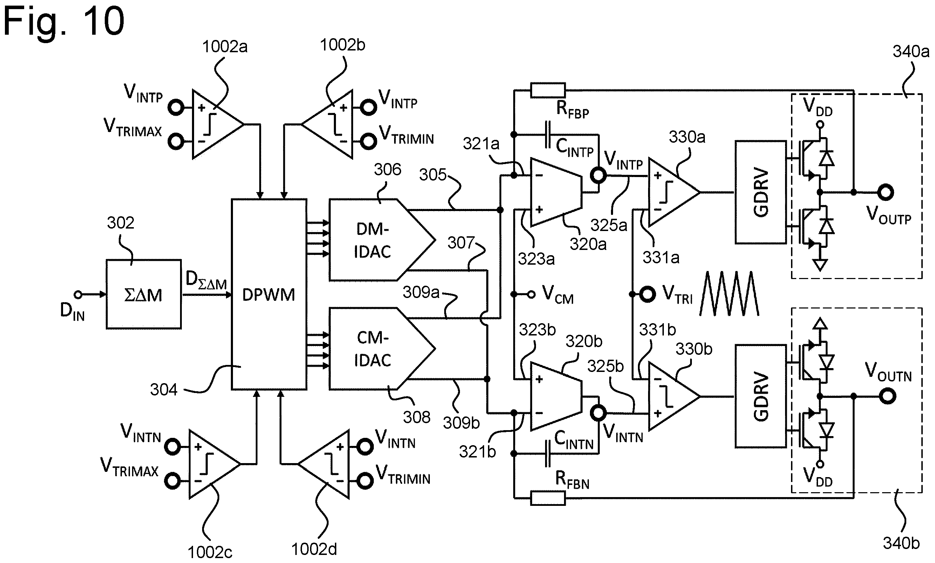

In an embodiment, the comparison of *V_{INTP}* and *V_{INTN}* to the upper and lower boundaries *V_{TRIMIN}* and *V_{TRIMAX}* of *V_{TRI}* can be implemented by adding four additional comparators 1002a, 1002b, 1002c and 1002d on top of the two comparators 330 as shown in Fig. 10.

However, the same can also be achieved with the existing comparators 330 by multiplexing the inverting input terminals 331 of the comparators 330 between *V_{TRI}*, *V_{TRIMIN}* and *V_{TRIMAX}* as shown in Fig. 11. Fig. 11 is similar to Fig. 3A with the addition of the block 1100 comprising a first set of switches and a second set of switches wherein the first ser of switches is connected to the comparator inverting input terminal 331a of the first comparator 330a and the second set of switches is connected to the comparator inverting input terminal 331b of the second comparator 330b. Each of the first and second sets of switches of block 1100 of Fig. 11 comprises a first, second and third switch respectively coupled to the maximum value *V_{TRIMAX}*, the minimum value *V_{TRIMIN}* and the triangular reference signal *V_{TRI}* such that the inverting input 331 can switch between the three values and the comparator 330 can provide a comparison with each of the three values when needed.

This provides a hardware efficient implementation and has the additional benefit that all comparisons have the same offset. Switching between different signals at the inverting input terminals 331 can be done with minimal disturbance at the peaks of *V_{TRI}* where the value is equal to either *V_{TRIMIN}* or *V_{TRIMAX}*.

The present invention may be exemplified or embodied in other specific forms without departing from its essential characteristics. The described examples are to be considered in all respects only as illustrative and not restrictive to the inventive concept. The scope of the invention is, therefore, indicated by the appended claims rather than by the foregoing description. It will be apparent to the person skilled in the art that alternative and equivalent examples of the invention can be conceived and reduced to practice. In addition, many modifications may be made to adapt a particular configuration or material to the teachings of the invention without departing from the essential scope thereof. All modifications which come within the meaning and range of equivalency of the claims are to be embraced within their scope.

## Claims

1. A differential amplifier circuit (300) comprising:
a pulse wide modulation, PWM, modulator (304) configured to receive a digital input signal to generate a PWM signal,;
a differential mode current digital to analog converter, DM-IDAC, (306) configured to receive the PWM signal from the PWM modulator (304) and provided a first and second differential mode current I_{DMP} and I_{DMN};
a common mode IDAC, CM-IDAC, (308) configured to receive the PWM signal from the PWM modulator (304) and provide a common mode current I_{CM};
a first and a second loop integrator (320); and
a first and a second comparator (330);
wherein each of the first and second loop integrators (320) comprise:
• a virtual ground node terminal (321) configured to receive the first and second differential mode current from the DM-IDAC (306), the common mode current from the CM-IDAC (308), and a feedback signal from an output stage (340) of the differential amplifier circuit (300) via a feedback loop (390); and
• an integrator output terminal (325) configured to provide a loop integrator output signal, which is proportional to an integral of the signals received at the virtual ground node terminal;
wherein each of the first and second comparators comprise:
• a comparator non-inverting input terminal configured to receive the loop integrator output signal;
• a comparator inverting input terminal configured to receive a triangular reference signal; and
• a comparator output terminal configured to provide a drive signal suitable for driving the output stage of the differential amplifier circuit.

2. The differential amplifier circuit (300) according to claim 1, further comprising a first set (360a, 370a) and a second set (360b, 370b) of loop integrators and a first (380a) and a second sum module (380b) wherein the first set of loop integrators (360a, 370a) is arranged in cascade with the first loop integrator (320a), the second set of loop integrators (360b, 370b) is arranged in cascade with the second loop integrator (320b), the first sum module (380a) is arranged to provide a weighted sum of the outputs of the first loop integrator (320a) and each of the loop integrators in the first set of loop integrators (360a, 370a) and the second sum module (320b) is arranged to provide a weighted sum of the outputs of the second loop integrator (320b) and each of the loop integrators in the second set of loop integrators (360b, 370b).

3. The differential amplifier circuit (300) according to any of claims 1 and 2, wherein the DM-IDAC (306) comprises four current sources (402) and four switches (406) wherein each of the current sources (402) is arranged to generate a first reference current (I_{REF}), and wherein the DM-IDAC (306) is arranged to receive four control signals to respectively control the four switches and to generate, based on the received four control signals, the first and second differential mode currents I_{DMP} and I_{DMN} to drive the virtual ground nodes terminals.

4. The differential amplifier circuit (300) according to claim 3, wherein the four control signals are generated by the DPWM modulator (304) by comparing the digital input signal respectively to a first and second staircase like reference signals (REF_{N}, REF_{P}) and wherein each of the first and second differential mode currents I_{DMP} and I_{DMN} can be I_{REF}, -I_{REF} or zero depending on the four control signals.

5. The differential amplifier circuit (300) according to claim 4, wherein the first differential mode current (I_{DMP}) is equal to:
• I_{REF} if the first staircase like reference signal (*REF_{P}*) is below the digital input signal;
• -I_{REF} if the second staircase like reference signal (*REF_{N}*) is above the digital input signal; and
• Zero otherwise.
and wherein the second differential mode current (I_{DMN}) is equal to:
• I_{REF} if the first staircase like reference signal (*REF_{P}*) is below the inverse of the digital input signal;
• -I_{REF} if the second staircase like reference signal (*REF_{N}*) is above the inverse of the digital input signal; and
• Zero otherwise.

6. The differential amplifier circuit (300) according to any of claims 1 and 2, wherein the CM-IDAC (308) comprises other four current sources (502) and other four switches (506) wherein each of the other four current sources (502) is arranged to generate a second reference current, and wherein the CM-IDAC (308) is arranged to receive other two control signals to respectively control the other four switches (506) and to generate, based on the received other two control signals, the common mode current I_{CM} to drive the virtual ground nodes terminals.

7. The differential amplifier circuit (300) according to claim 4, wherein the other two control signals are generated by the DPWM modulator (304) and wherein the common current I_{CM} is equal to I_{REF}/2 or to I_{REF}.

8. The differential amplifier circuit (300) according to claim 5, wherein the common mode current I_{CM} is equal to:
• I_{REF} if a shifted version of the first staircase like reference signal (*REF_{P}*) is below the digital input signal and a shifted version of the second staircase like reference signal (*REF_{N}*) is above the inverse of the digital input signal; and
• I_{REF}/2 if the shifted version of the first staircase like reference signal (*REF_{P}*) is below the digital input signal or the shifted version of the second staircase like reference signal (*REF_{N}*) is above the inverse of the digital input signal; and
• Zero otherwise.

9. The differential amplifier circuit (300) according to claim 6, wherein the shifted version of the first and second staircase like reference signals is respectively generated by adding a value N_{SKIP} to the first staircase like reference signal and by subtracting the value N_{SKIP} to the second staircase like reference signal.

10. The differential amplifier circuit (300) according to any of claims 1 and 2, further configured to generate a feedback common current I_{CMFB}, wherein the feedback common current I_{CMFB} is equal to I_{REF}/2 between a first and a second time wherein the first time is a time at which the triangular reference signal reaches its minimum value (*V_{TRIMIN})* and the loop integrator output signal of the first loop integrator or the loop integrator output signal of the second loop integrator is below the minimum value (*V_{TRIMIN}*), and the second time is another time at which the loop integrator output signal of the first loop integrator or the loop integrator output signal of the second loop integrator reaches the minimum value (*V_{TRIMIN})* and wherein the CM-IDAC generates the feedback common current.

11. The differential amplifier circuit (300) according to any of claims 1 and 2, further comprising another IDAC configured to generate a current if, when the triangular reference signal reaches its maximum value *(V_{TRIMAX})*, the loop integrator output signal of the first loop integrator or the loop integrator output signal of the second loop integrator is above the maximum value *(V_{TRIMAX})*.

12. The differential amplifier circuit (300) according to any of claims 1 and 2, wherein the DM-IDAC is configured to stop generating the first and second differential mode currents if, when the triangular reference signal reaches its maximum value *(V_{TRIMAX})*, the loop integrator output signal of the first loop integrator or the loop integrator output signal of the second loop integrator is above the maximum value *(V_{TRIMAX})*.

13. The differential amplifier circuit (300) according to any of claims 1 and 2, further comprising at least one of a first, second, third and fourth extra comparators respectively configured to compare a maximum value *(V_{TRIMAX})* of the triangular reference signal and the loop integrator output signal of the first loop integrator, a minimum value (*V*_{*TRIMIN*)} of the triangular reference signal and the loop integrator output signal of the first loop integrator, the maximum value *(V_{TRIMAX})* and the loop integrator output signal of the second loop integrator, and the minimum value (*V*_{*TRIMIN*)} and the loop integrator output signal of the second loop integrator.

14. The differential amplifier circuit (300) according to any of claims 1 and 2, where the comparator non-inverting input terminal of the first comparator is coupled to a first set of switches and the comparator non-inverting input terminal of the second comparator is coupled to a second set of switches wherein each of the first and second sets of switches comprises a first, second and third switch respectively coupled to the maximum value *(V_{TRIMAX})*, the minimum value (*V*_{*TRIMIN*)} and the triangular reference signal.

15. The differential amplifier circuit (300) according to any of the preceding claims, wherein the PWM signal is representative of a difference between the first and second staircase like reference signals and the digital input signal.
